# EUROPEAN PATENT SPECIFICATION

(11) **EP 2 527 298 B1**
(45) Date of publication and mention of the grant of the patent: **09.03.2016**
(21) Application number: 10860442.2
(22) Date of filing: 07.12.2010
(51) Int. Cl.: C01G 15/00, C01G 3/00, C01B 19/00, B82Y 30/00, H01L 21/02, H01L 31/032

(54) **CHALCOGEN COMPOUND POWDER, CHALCOGEN COMPOUND PASTE AND METHOD OF PRODUCING THESE**
PULVER AUS EINER CHALCOGENVERBINDUNG, PASTE AUS EINER CHALCOGENVERBIDNUNG UND VERFAHREN ZU IHRER HERSTELLUNG
POUDRE DE COMPOSÉ CHALCOGÈNE, PÂTE DE COMPOSÉ CHALCOGÈNE ET LEUR PROCÉDÉ DE PRODUCTION

(43) Date of publication of application: 28.11.2012
(73) Proprietor: DOWA Holdings Co., Ltd, Tokyo 101-0021 (JP)
(72) Inventor: ISHIKAWA Yuichi, Tokyo 101-0021 (JP); TANOUE Koji, Tokyo 101-0021 (JP); FUJINO Takatoshi, Tokyo 101-0021 (JP)
(74) Representative: Müller-Boré & Partner Patentanwälte PartG mbB
(86) International application number: PCT/JP2010/072319
(87) International publication number: WO 2012/077243

(56) References cited:
- WO-A1-2009/041758
- JP-A- 3 068 775
- JP-A- 2002 501 003
- JP-A- 2010 105 887
- JP-A- 2010 132 521
- JP-A- 2010 155 730
- JP-A- 2010 526 007
- JP-A- 2011 016 707
- US-A1- 2010 003 187
- SURYANARAYANA C ET AL: "CONSOLIDATION OF MECHANICALLY ALLOYED CU-IN-GA-SE POWDERS", JOURNAL OF MATERIALS SCIENCE LETTERS, vol. 20, no. 24, 15 December 2001 (2001-12-15), pages 2179-2181, XP001089060, CHAPMAN AND HALL LTD. LONDON, GB ISSN: 0261-8028, DOI: 10.1023/A:1017916530073
- DATABASE WPI Week 201033 Thomson Scientific, London, GB; AN 2010-F18739 XP002701133, & JP 2010 105887 A (DOWA ELECTRONICS CO LTD) 13 May 2010 (2010-05-13)

## Description

The present invention relates to chalcogen compound powder and chalcogen compound paste containing a chalcogen-base element for use to form an optical absorption layer of a thin-film solar cell, a fluorescent substance or an electrode film for a Peltier device or to do the like, and also processes for producing the chalcogen compound powder and chalcogen compound paste, and more particularly to chalcogen compound powder, chalcogen compound paste and processes for producing the chalcogen compound powder and chalcogen compound paste, which are low in cost and danger and further capable of reducing electrical resistance of a film formed by coating and calcination of the chalcogen compound paste using the chalcogen compound powder.

As nanosize powders of metal compounds, chalcogen compounds, such as, for example, semiconductor nanocrystals, particularly, cadmium telluride (CdTe), cadmium selenide (CdSe) and cadmium sulfide (CdS), and copper-indium-gallium-selenium (CuInGaSe) and copper-indium-selenium (CuInSe), allow controlling an optical absorption spectrum or light emission by use of their diameter size effect and also allows controlling a band gap of the compound by formation of a solid solution. Therefore, in recent years, research and development has actively been carried out also on their application to solar cells. A substance represented as : CuInₓGa₁₋ₓSe_{y}S_{2-y} (where 0 ≤ x ≤ 1, and 0 ≤ y ≤ 2), in particular, is expected to be applied to a solar cell or a fluorescent substance, because of being superior in its capability of allowing easy control of the band gap by changing a ratio between In and Ga.

For use in a solar cell, CuInₓGa₁₋ₓSe₂ is used in the form of filmy crystals. Currently, there is a method to form a metal film made up of Cu, In and Ga, and to subject the metal film to a selenization process.

As an example of a synthesis method for CdSe nanocrystals as nanoparticles of a chalcogen compound, the synthesis of CdSe nanocrystals using dimethylcadmium (Cd(CH₃)₂) as a cadmium precursor has been developed since the first report (Refer to non patent literature.) by Murray et al. Note that, as used herein, the chalcogen compound refers to a compound containing one or more kinds of metallic elements, and one or more kinds of elements selected from Se and S, as constituent elements.

Also, Barbera-Guillem et al. have disclosed a continuous flow process for production of nanocrystals using the method of Murray et al. (Refer to patent document 1.)

Also known is a method of using metal oxides or metal salts, which are inexpensive and non-pyrophoric materials, as a precursor, to form soluble metal complexes by combining the metal oxides or metal salts with a ligand and a coordinating solvent, and to form nanocrystals by introducing an elemental chalcogenic precursor (selenium (Se), tellurium (Te), sulfur (S) or the like) into the soluble metal complexes. (Refer to patent literature 2.)

Further, the applicant has developed a method in which a metal compound and selenium are mixed with and heated in a high boiling point solvent thereby to yield less dangerous and nanoparticles (nanocrystals) with excellent crystallinity of a chalcogen compound. (Refer to patent document 3.)
Patent Document 1 : Specification of U.S. Patent No. 6,179,912
Patent Document 2 : Japanese Patent Publication No. 2004-510678
Patent Document 3 : Japanese Patent Publication No. 2010-132521

Non Patent Document 1 : Journal of the American Chemical Society (1993), 115, 8706-8715

Further, US 2010/0003187 A1 discloses a method for synthesizing a chalco-genide nanoparticle, comprising reacting a metal component with a chalcogen precursor in the presence of an organic solvent having at least one of a boiling temperature equal to 220°C or above and a chain length of about 12 carbon atoms or above.

WO 2009/041758 A1 discloses a method for preparing a chalcopyrite-type compound represented by the formula CuM¹M²₂, wherein M¹ is one or more selected from among group III elements, and M² is one or more selected from among group VI elements, said method comprising the steps of a) mixing a Cu salt, a group III element salt and a group VI element powder with a chelating agent, an ionic liquid or a chelating agent/ionic liquid mixture to prepare a mixture solution; and b) introducing the mixture solution into a reactor and heating the introduced mixture solution by microwave irradiation.

J. Mat. Sci. Let. 20, 2001, pp. 2179-2181 relates to an investigation on the consolidation of a mechanically alloyed CuIn_{0.7}G_{0.3}Se₂ powder.

JP 2010-105887 A discloses a method for producing a nanoparticle of specific chalcogen compounds in which a chalcogen source containing one or more kinds of a hydroxide, an oxide and an oxalate and one or more kinds of Se, Te and S are added into a reducing solvent and heated to 200°C or higher.

Among chalcogen compounds, nanoparticles (nanocrystals) of a compound made up of Cu-In-(Ga)-Se-(S) are expected to be formed into a thin film for use in solar cell production. As used herein, (Ga) and (S) in the expression Cu-In-(Ga)-Se-(S) indicate that Ga and/or S may be excluded, and (Ga) in the expression Cu-In-(Ga)-Se indicates that gallium (Ga) may be excluded. (The same goes for the following description.)

Although a conventional method for forming a chalcogen compound made up of Cu-In-(Ga)-Se-(S) into a thin film is to form a metal film made up of Cu and In or made up of Cu, In and Ga and subject the metal film to a selenization process, the method has problems with homogeneity or productivity of the film.

For example, if chalcogen compound powder which particles (herein called nanoparticles unless otherwise specified) having an average particle diameter (D_{SEM}) of 80 nm or less measured by observation under a scanning electron microscope (hereinafter, SEM) is obtained, a thin film of chalcogen compound having high homogeneity can be obtained at low cost.

Therefore, the applicant has developed the method disclosed in patent document 3. This makes it possible to obtain chalcogen compound nanoparticles having high crystallinity and an average particle diameter of 60 nm or less, with safety at low cost.

However, a thin film for a solar cell formed by using the chalcogen compound obtained by the above-described method has a problem of having high electrical resistance. Specifically, it is preferable that the thin film of a chalcogen compound for use in the solar cell or the like have a sheet resistivity of 1000 Ω/□ (Ω/sq) or less. However, the thin film formed by pasting and calcination of the nanoparticles of the chalcogen compound obtained by the method disclosed in the prior patent application has a high sheet resistivity of 10 MΩ/□ or more. This can be attributed to the fact that powder of the nanoparticles of the chalcogen compound obtained by the method disclosed in the prior patent application contains more than 5% by mass of organic matter.

In order to solve the above-described problems, a first aspect of the present invention is to provide a chalcogen compound powder represented as a general formula: CuₐIn_{b}Ga_{1-b}Se_{c} (where 0.65 ≤ a ≤ 1.2, 0 < b ≤ 1, and 1.9 ≤ c ≤ 2.4), having an average particle diameter (D_{SEM}) of 1 nm to 80 nm measured by observation under a scanning electron microscope, and having a carbon content of 0.5% or less by mass.

A second aspect of the present invention is to provide chalcogen compound paste containing the chalcogen compound powder and a disperse medium.

A third aspect of the present invention is to include the steps of: forming a mixed solvent by mixing together a metal source containing copper and indium, any one of selenium and a selenium compound, and a polar solvent; and heating the mixed solvent to a temperature of 220°C to 500°C using a vessel capable of being heated under pressure, wherein the polar solvent is an organic solvent, selected from methyl alcohol or ethyl alcohol, or a mixed solvent of the organic solvent and water, wherein the solvent contains 70% or less by mass of water.

A fourth aspect of the present invention is to include the step of mixing together the chalcogen compound powder obtained by the above-described process and a disperse medium.

According to an embodiment of the present invention, firstly, high-quality chalcogen compound powder containing Cu-In-(Ga)-Se and having an average particle diameter of 1 nm to 80 nm and a low content of carbon can be obtained using an inexpensive metal source as raw material. Also, a process for producing chalcogen compound powder, which is low in cost and danger, can be provided.

Secondly, chalcogen compound paste capable of reducing a resistance value of a film obtained by coating and heating of the paste to 1000 Ω/□ or less can be obtained by pasting of the chalcogen compound powder. Also, a process for producing chalcogen compound paste, which is low in cost and danger, can be provided.
Figs. 1A to 1C are flowcharts of assistance in explaining production processes of an embodiment of the present invention.
Fig. 2 shows results of evaluation of the state of specimens according to Example 1 of the present invention.
Fig. 3 is a graph of particle size distribution according to Example 1 of the present invention.
Fig. 4 shows results of fluorescent X-ray analysis of chalcogen compound powder according to Example 1 of the present invention.
Fig. 5 is a graph showing results of X-ray diffraction of the chalcogen compound powder according to Example 1 of the present invention.
Fig. 6 shows results of evaluation of the state of specimens according to Comparative example 1 of the present invention.
Fig. 7 is a graph showing results of X-ray diffraction of chalcogen compound powder according to Comparative example 1 of the present invention.
Fig. 8 shows results of evaluation of the state of specimens according to Comparative example 2 of the present invention.
Fig. 9 shows results of evaluation of carbon content performed on Example 1 and Comparative example 2 of the present invention by wavelength dispersive X-ray fluorescence analysis.
Fig. 10 shows results of measurement of sheet resistivity of thin films of chalcogen compounds, made on Example 1 and Comparative example 2 of the present invention.
Fig. 11 shows results of evaluation of the carbon content of the thin films of chalcogen compounds, performed on Example 1 and Comparative example 2 of the present invention by SEM-EDS.
Fig. 12 shows results of evaluation of the state of specimens according to Example 2 of the present invention.
Fig. 13 shows results of fluorescent X-ray analysis of chalcogen compound powder according to Example 2 of the present invention.
Fig. 14 is a graph showing results of X-ray diffraction of the chalcogen compound powder according to Example 2 of the present invention.
Fig. 15 shows results of evaluation of the state of specimens according to Comparative example 3 of the present invention.
Fig. 16 shows results of evaluation of the state of specimens according to Example 3 of the present invention.
Fig. 17 is a graph of particle size distribution according to Example 3 of the present invention.
Fig. 18 shows results of fluorescent X-ray analysis of chalcogen compound powder according to Example 3 of the present invention.
Fig. 19 is a graph showing results of X-ray diffraction of the chalcogen compound powder according to Example 3 of the present invention.
Fig. 20 shows results of evaluation of the state of specimens according to Comparative example 4 of the present invention.
Fig. 21 shows a scanning electron microscope photograph of a specimen 1 according to Example 5 of the present invention.
Fig. 22 shows results of evaluation of the state of specimens according to Example 5 of the present invention.
Fig. 23 shows results of fluorescent X-ray analysis of chalcogen compound powder according to Example 5 of the present invention.
Fig. 24 shows results of measurement of carbon content made on Example 5 of the present invention, using wavelength dispersive X-ray fluorescence analysis.
Fig. 25 shows results of measurement of sheet resistivity of thin films of chalcogen compounds according to Example 5 of the present invention.
Fig. 26 shows results of evaluation of the state of specimens according to Example 6 of the present invention.
Fig. 27 shows results of fluorescent X-ray analysis of chalcogen compound powder according to Example 6 of the present invention.
Fig. 28 shows results of evaluation of the state of specimens according to Example 7 of the present invention.
Fig. 29 is a graph of particle size distribution according to Example 7 of the present invention.
Fig. 30 shows results of fluorescent X-ray analysis of chalcogen compound powder according to Example 7 of the present invention.
Fig. 31 is a graph showing results of X-ray diffraction of the chalcogen compound powder according to Example 7 of the present invention.
Fig. 32 shows results of evaluation of the state of specimens according to Comparative example 7 of the present invention.

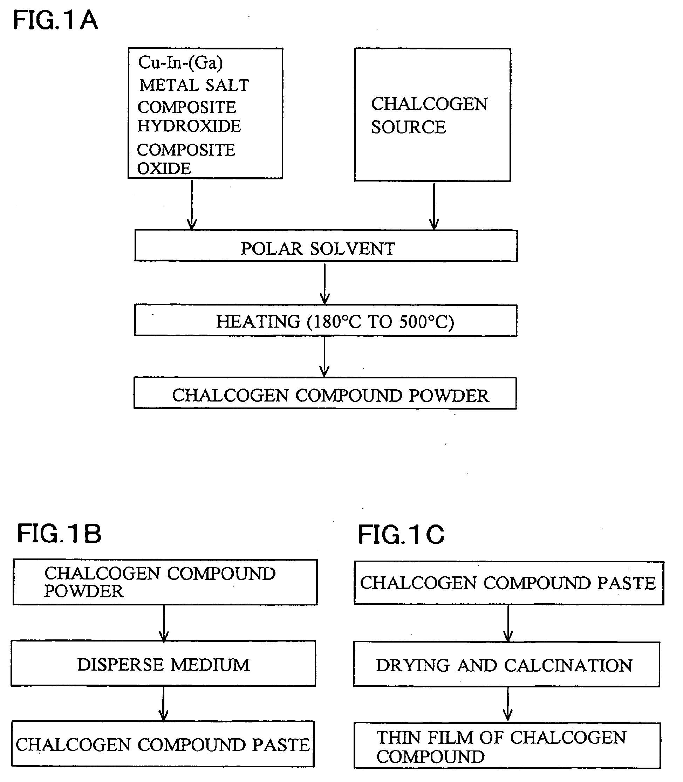

An embodiment of the present invention will be described in detail below with reference to Figs. 1A to 32.

Chalcogen compound powder of the embodiment is a compound containing copper (Cu), indium (In) and selenium (Se), represented as a general formula: CuₐIn_{b}Ga_{1-b}Se_{c} (where 0.65 ≤ a ≤ 1.2, 0 < b ≤ 1, and 1.9 ≤ c ≤ 2.4), having an average particle diameter (D_{SEM}) of 1 nm to 80 nm measured by observation under a scanning electron microscope, and having a low content of carbon. As used herein, (Ga) in the expression Cu-In-(Ga)-Se indicates that gallium (Ga) may be excluded. (The same goes for the following description.) Also, it is preferable that the value of b is equal to or more than 0.4. If the value of b is less than 0.4, a band gap of the chalcogen compound becomes large, and thus, use of the chalcogen compound powder for production of a solar cell may possibly lead to a reduction in conversion efficiency of the solar cell.

Also, the chalcogen compound of the embodiment is the compound containing one or more kinds of metallic elements, and one or more kinds of elements selected from selenium (Se), as constituent elements.

Figs. 1A to 1C are flowcharts of assistance in explaining examples of production processes for obtaining chalcogen compound powder, chalcogen compound paste, and a thin film of chalcogen compound, respectively, of the embodiment.

Firstly, a process for producing chalcogen compound crystal powder of the embodiment will be described with reference to Fig. 1A. The process for producing the chalcogen compound crystal powder of the embodiment includes a step of forming a mixed solvent by mixing together a metal source containing copper and indium, one or more kinds of selenium and selenium compounds (a chalcogen source), and a polar solvent, and a step of heating the mixed solvent to a temperature of 220°C to 500°C using a vessel capable of being heated under pressure, wherein the polar solvent is an organic solvent, selected from methyl alcohol or ethyl alcohol, or a mixed solvent of the organic solvent and water, wherein the solvent contains 70% or less by mass of water.

Thus, the mixed solvent formed by mixing together the metal source, the chalcogen source and the solvent is heated under predetermined conditions to undergo chalcogenization reaction and thereby enable formation of a predetermined chalcogen compound.

This process enables obtaining chalcogen compound powder having an average particle diameter (D_{SEM}) of 1 nm to 80 nm inclusive.

Powder containing at least any one of a mixture of copper salt and indium salt, a composite hydroxide of copper and indium, and a composite oxide of copper and indium may be used for the metal source as raw material.

As used herein, the mixture refers to a mixture of metal salts obtained by mixing together copper salt and indium salt. The composite hydroxide refers to a composite of metal hydroxides formed by dissolving copper salt and indium salt in a solvent and adding alkali to the solvent. Also, the composite oxide refers to a composite of metal oxides obtained by oxidation (dehydration) of a composite hydroxide.

Also, the metal source may contain gallium (Ga). Specifically, powder containing at least any one of a mixture of copper salt, indium salt and gallium salt, a composite hydroxide of copper, indium and gallium, and a composite oxide of copper, indium and gallium may be used.

Then, when a mixture of metal salts (copper salt and indium salt) is used as starting material, the mixture is dissolved in a solvent, and alkali is added to the solvent to precipitate a composite hydroxide of Cu and In, and thereafter, decantation, centrifugal sedimentation, filtration or the like is performed, and rinsing takes place as needed, and drying is done, whereby metal compound powder of the composite hydroxide is obtained. Alternatively, a composite hydroxide is oxidized (dehydrated) to yield metal compound powder of a composite oxide.

The average primary particle diameter of the metal compound powder of the composite hydroxide can be adjusted by changing the following conditions at the time of formation of the composite hydroxide. The average primary particle diameter tends to become larger as the concentration of Cu salt becomes higher, the average primary particle diameter tends to become large when a liquid is weakly stirred at the time of addition of alkali, and the average primary particle diameter tends to become large when the time for the addition of alkali is long. The average particle diameter of the chalcogen compound powder can be adjusted by adjusting the average primary particle diameter of the composite hydroxide.

In the following example, description will be given taking an instance where a mixture of metal salts is used as starting material to form a composite hydroxide or a composite oxide and thereby yield a chalcogen compound; however, metal compound powder of a composite hydroxide or metal compound powder of a composite oxide may be used as starting material.

First, Cu salt and In salt are dissolved in a solvent. Water may be used as the solvent. After that, alkali is added to the solvent thereby to induce neutralization and form a metal hydroxide. Specifically, an aqueous solution of ammonia, sodium hydroxide, potassium hydroxide, or an alkaline organic compound having an amino group is used to form a precipitate as the metal hydroxide.

At this time, since a chalcogen compound to be obtained is the compound containing plural metallic elements, composition of metal salts is such that metal salts of at least Cu and In are used for formation of a metal hydroxide in order to obtain a precipitate of a metal hydroxide having the same metallic element ratio as that of the chalcogen compound. Specifically, for example for production of CuInSe₂, copper salt and indium salt are used as raw materials to form a metal hydroxide so that an atomic ratio between Cu and In stands at 1:1.

Also, for example for production of CuIn_{0.8}Ga_{0.2}Se₂, copper salt, indium salt and gallium salt are used as raw materials to form a metal hydroxide so that an atomic ratio of Cu, In and Ga stands at 1 : 0.8 : 0.2.

Cleaning is performed on a slurry containing these metal hydroxides by repeating an operation that involves removing once the solvent containing a reaction by-product by a centrifugal hydroextractor, a high-speed centrifugal settling tube, a filter press, a Nutsche or the like, redispersing in a solvent such as water or ethyl alcohol, and further removing the solvent. Desirably, the cleaning is repeated until electrical conductivity of a removed solvent (filtrate) reaches 10⁻¹ Sm⁻¹ or less. Alkali metal in particular, if remaining, does not volatilize and hence remains as an impurity element, which in turn can possibly become a problem.

Reaction impurities can be removed by performing the cleaning. In the embodiment, for neutralization, it is preferable that an end point of pH be alkaline. The pH is not particularly limited but may be equal to or more than 10, for example. Also, it is better to perform rinsing such that the electrical conductivity of the filtrate becomes lower; however, when the pH gets closer to neutral, the metal hydroxide in itself is eluted and hence changes in composition, and therefore, it is desirable that the pH of the filtrate be maintained at 7.5 or more.

Any one of cake containing the solvent obtained by solid-liquid separation of the hydroxide after the cleaning, a hydroxide obtained by a method given below, an oxide obtained by the method given below, and a mixture of the hydroxide and the oxide can be used as a metal source of chalcogenization reaction to be described later.

Powder of a composite hydroxide (metal compound powder) can be obtained by drying the metal hydroxide obtained by the solid-liquid separation after the cleaning, for example at a temperature of 70°C to 90°C under an atmosphere of air. At this time, drying temperature is not particularly limited, and vacuum drying may be adopted to reduce the drying temperature. Also, the drying temperature may be equal to or higher than 200°C. Also, the composite hydroxide may be heated and oxidized to form powder of a composite oxide (metal compound powder).

Specifically, after the electrical conductivity of the filtrate has reached 10⁻¹ Sm⁻¹ or less by the cleaning, the water content of the slurry containing the composite hydroxide is adjusted to 50% or less, and the slurry (or the cake) is dispersed again in the solvent.

A gas such as air, nitrogen or argon is introduced into the solvent containing the composite hydroxide to evaporate water to the outside (produce bubbling), and the solvent is heated within its temperature range of 70°C to 300°C thereby to change the composite hydroxide in the solvent into a metal oxide or into a mixture of a metal oxide and a metal hydroxide, and to dissociate the flocculated metal hydroxide, thus enabling the solvent to enter a state in which powder having a primary particle size of 1 to 200 nm is present in a green state in the solvent.

At this time, molecules in themselves of the solvent may be enveloped in the particles in the form of chemical bonding or physical adsorption thereby to disperse the particles in the solvent. Alternatively, a surface-active agent may be added to the solvent to disperse the particles in the solvent. The particles thus dispersed in the solvent are desirable because flocculation or sintering of the particles can be prevented in surface treatment on the particles or other reaction processes with the particles.

For this reaction at the time of oxidation, the bubbling may take place as described above since water is released into the solvent; however, the solvent may be heated to high temperature in an autoclave to accelerate the oxidation reaction.

Also, an instance is here given where the formation of the composite oxide takes place after the cleaning of the composite hydroxide; however, the cleaning operation may be performed after the composite hydroxide has been formed and then heated in one and the same solvent to form the composite oxide. Also, when the formation of the composite hydroxide and the chalcogenization reaction take place in one and the same solvent, the cleaning operation may be performed after the chalcogenization reaction. The cleaning, even if performed at any stage, enables appropriate elimination of the reaction impurities.

Then, the metal compound powder of the composite hydroxide or the composite oxide is mixed with a polar solvent, the chalcogen source (selenium (Se), a selenium compound, or a mixture of these) is added to the solvent to form a mixed solvent, and the mixed solvent is heated.

As used herein, the polar solvent refers to an organic solvent, selected from methyl alcohol or ethyl alcohol, or a mixed solvent of the organic solvent and water. The organic solvent may be a mixed solvent of two kinds of organic solvents. Desirably, the boiling point of the organic solvent is lower from the viewpoint of reduction of the carbon content in chalcogen compound powder obtained. When the mixed solvent of the organic solvent and water is used as the polar solvent, the water content in the polar solvent is set equal to or less than 70% by mass; however, it is preferable that the water content be set equal to or less than 50% by mass from the viewpoint of acceleration of the chalcogenization reaction.

Hydrogen selenide (H₂Se) is given as an example of the selenium compound.

Then, the mixed solvent of the chalcogen source with the metal compound powder and the polar solvent is heated to a temperature of 220°C to 500°C. Thereby, the mixed solvent of the chalcogen source with the metal compound powder and the polar solvent undergoes chalcogenization reaction to facilitate obtaining chalcogen compound powder. If the heating temperature (the temperature for the chalcogenization reaction, hereinafter called reaction temperature) is low, the formation of the chalcogen compound may possibly be imperfectly achieved, while even with a temperature of 400°C or more, there is no significant change in the state of formation of the obtained chalcogen compound, and therefore, the temperature is preferably between 220°C and 400°C, or more preferably between 250°C and 400°C.

When the boiling point of the polar solvent exceeds 220°C and does not exceed 250°C, the reaction temperature is set to a temperature of not less than 220°C nor more than the boiling point of the polar solvent thereby to enable the chalcogenization reaction to occur at normal pressure; however, in order to reduce the carbon content in the obtained chalcogen compound powder to a lower content, it is preferable that the temperature of the polar solvent is equal to or less than 200°C, and in this case, it is required that the chalcogenization reaction occur in an environment under normal pressure or higher. Thus, a vessel capable of being heated in an environment under pressure is used for the chalcogenization reaction.

In the embodiment, it is thought as follows, the polar solvent is heated to the above-described temperature range and thereby the solvent acts as a reducing agent to reduce the metal compound powder, and also, Se as the chalcogen source is allowed to react with the reduced metal and thereby the chalcogen compound powder can be obtained with ease. Also, particles of the chalcogen compound powder thus prepared are of size such that the average particle diameter (D_{SEM}) is between 1 nm and 200 nm, and the powder having no sintering or bond between the particles can be obtained. The chalcogen compound powder having an average particle diameter (D_{SEM}) of 1 nm to 80 nm can be obtained by adjusting the particle diameter of the metal compound powder.

The chalcogen compound powder obtained by the embodiment has an X-ray diffraction peak intensity ratio (a value obtained by dividing a peak height of the highest peak intensity of a target chalcogen compound by a peak height of the highest peak of other substances) of 8 or more, and contains a high concentration of particles made up of crystals having a target composition. The chalcogen compound powder (the general formula: CuₐIn_{b}Ga_{1-b}Se_{c} (where 0.65 ≤ a ≤ 1.2, 0 < b ≤ 1, and 1.9 ≤ c ≤ 2.4)) is used to form a film and thereby permit expecting an improvement in characteristics of the formed film.

To obtain a chalcogen compound film by lower-temperature calcination, the average particle diameter (D_{SEM}) of the chalcogen compound powder is preferably between 1nm and 80 nm, or more preferably between 1nm and 60 nm. Still more preferably, the average particle diameter (D_{SEM}) is between 1nm and 20 nm because of making it possible to obtain the chalcogen compound film even with a calcination temperature of the order of 200°C. When the average particle diameter (D_{SEM}) exceeds 80 nm, high calcination temperature is necessary. The chalcogen compound powder having an average particle diameter (D_{SEM}) of less than 1 nm is difficult to obtain.

Also, cleaning operation for removing impurity contamination produced at the time of formation of the composite hydroxide may be performed after the preparation of the chalcogen compound powder through the addition of the chalcogen source. The cleaning, even if performed at any stage, enables appropriate elimination of the reaction impurities.

Incidentally, the order of mixing and addition of the chalcogen source with and to the metal compound powder and the polar solvent is not limited to the above-described example. Specifically, in a step of forming the composite hydroxide from the metal salts, the solvent which added the polar solvent to pure water may be used as a dissolving liquid for the metal salts. Also, the polar solvent may be used as the solvent in a step of forming the composite oxide from the composite hydroxide (oxidizing the composite hydroxide to the composite oxide). Further, the polar solvent may be added at the time of addition of the chalcogen source, besides the use of the polar solvent as the solvent in the step of forming the composite oxide from the composite hydroxide (oxidizing the composite hydroxide to the composite oxide).

In the embodiment, at the time of start of the chalcogenization reaction, if concentration of solids of the metal compound in the liquid is low, it is easy to disperse and hence little flocculation occurs, but the amount of production per reaction becomes small, while on the contrary, if the concentration of solids is high, bonds between resultant chalcogen compound particles or flocculation of the particles is easy to occur, and therefore, it is preferable that, at the time of start of the chalcogenization reaction, the solids concentration of the metal compound is between 0.1% and 50% by mass. More preferably, the solids concentration is between 0.1% and 10% by mass.

Also, preferably, the amount of the chalcogen source added at the time of the chalcogenization reaction is 1 to 1.5 times of the equivalent is added, because too much addition is uneconomical.

In the embodiment, hereinafter, the phrase "excessive addition" means the addition of an amount exceeding 1 time the equivalent and not exceeding 1.5 times the equivalent. As used herein, specifically for example, the equivalent refers to the amount of the chalcogen source containing 2.1 moles of Se relative to 1 mole of Cu contained in the metal source of the chalcogenization reaction, for production of chalcogen compound powder of CuInSe_{2.1}.

Thereby, the chalcogen compound powder can be obtained. The chalcogen compound powder contains slight carbon. When the boiling point of the solvent for use in the chalcogenization reaction is high as is the case with the embodiment, the carbon is not completely eliminated with the above-described cleaning step and hence is contained in the chalcogen compound powder; however, in the embodiment, the carbon content in the chalcogen compound powder can be reduced to 0.5% or less by mass.

Next, chalcogen compound paste and a process for producing the same of the embodiment will be described with reference to Figs. 1B and 1C. Further, description will be given with regard to an evaluation method for a film obtained by coating and calcination of the paste.

As shown in Fig. 1B, the chalcogen compound powder prepared as described above is mixed with a disperse medium. A liquid such as alcohol (including polyhydric alcohol) may be used as the disperse medium. For example, diethylene glycol or the like may be used. Also, it is preferable that the content of the chalcogen compound powder in the chalcogen compound paste is between 20% and 80% by mass. A content of 20% or less by mass may possibly cause a problem with patterning at the time of coating, while a content of 80% or more by mass may possibly lead to the paste having too high a viscosity. While being stirred, the chalcogen compound powder and the disperse medium are mixed together to form the chalcogen compound paste. Incidentally, the chalcogen compound paste of the embodiment refers to that in a state in which the chalcogen compound powder is dispersed in the disperse medium.

Then, as shown in Fig. 1C, the obtained chalcogen compound paste is coated and dried. After that, calcination takes place for example in an atmosphere of argon (Ar) thereby to form a thin film of chalcogen compound. In the embodiment, measurement is made of sheet resistivity of the chalcogen compound film obtained by coating and calcination of the chalcogen compound paste using diethylene glycol as the disperse medium.

For the thin film of chalcogen compound for use in the solar cell or the like, it is desired that the sheet resistivity of the film is low. Specifically, the sheet resistivity is preferably equal to or less than 1000 Ω/□ (Ω/sq), or more preferably equal to or less than 800 Ω/□, or still more preferably equal to or less than 500 Ω/□.

The thin film of chalcogen compound using the chalcogen compound powder obtained by the conventional method (the method disclosed in the prior patent application) has the problem of having high sheet resistivity (e.g. 10 MΩ/□ or more), because of high content of organic matter (e.g. carbon (C)) in dry powder containing the chalcogen compound powder.

Because the dry powder including the chalcogen compound powder made by the present embodiment has little organic matter included in it and thus, when the thin film of chalcogen compound is formed, the sheet resistivity can be reduced to less than 1000 Ω/□.

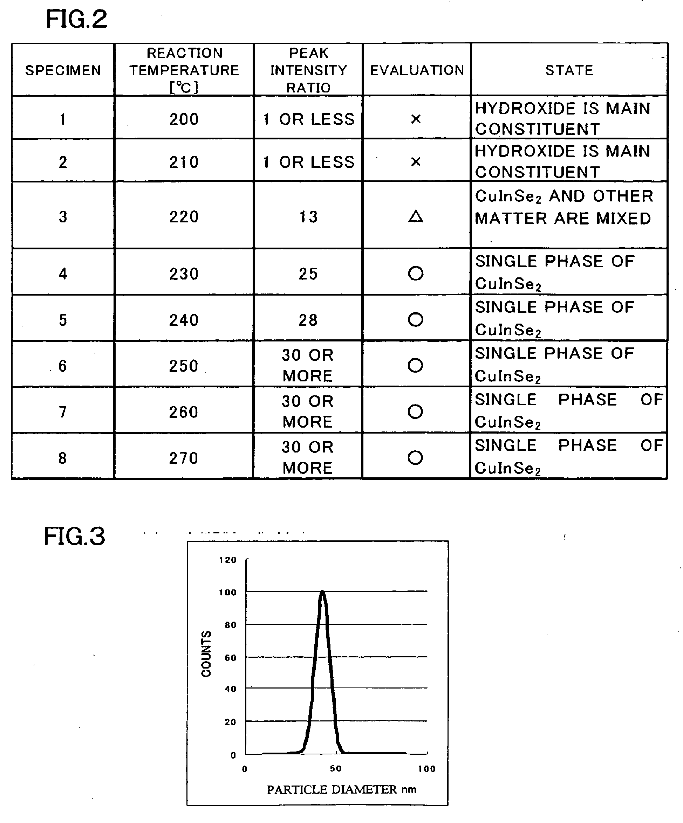

Examples will be given in detail below with reference to Figs. 2 to 32. Incidentally, in the following examples, even if there is a difference between an element composition ratio of elements of an obtained chalcogen compound and an element composition ratio intended to be formed, a molecular formula for the element composition ratio intended to be formed may be used for representation, provided that the difference is equal to or less than 5%.

### EXAMPLE 1

To synthesize CuInSe₂ particles, a solution containing 0.1 mol of copper nitrate and 0.1 mol of indium nitrate dissolved in 500 mL of pure water was poured into a 1000 mL beaker. Subsequently, with the solution in the beaker stirred with a blade of 5 cm in diameter at 300 rpm, a 40 g/L aqueous solution of sodium hydroxide was dripped until the solution reached pH 7.8, thereby to form a precipitate as a hydroxide and obtain a composite hydroxide of copper and indium. In this state, the composite hydroxide was allowed to stand for 30 minutes, and thereafter, solid-liquid separation was performed by a Nutsche. At this time, extracted cake of the hydroxide of copper and indium was dispersed again in pure water, and the water was filtered through the Nutsche in the same manner. Filtration was repeated until conductivity of filtrate reached 10⁻³ Sm⁻¹ or less. Part of the cake taken out was dried by heat (at 80°C for 12 hours in an atmosphere of air), and a water content in the cake was determined from mass before and after drying by heat. The obtained water content in the cake was 73% by mass.

Then, 5 g of the composite hydroxide after the drying was taken out. Se powder was prepared by being weighed in an amount such that an atomic ratio of Se to Cu contained in the composite hydroxide stands at 2.2. Then, 5 g of the composite hydroxide and the weighed Se powder were put in a 50 mL vessel made of fluorocarbon resin, and 20 mL of ethyl alcohol was added to them. In this state, the resultant mixture was agitated to disperse the hydroxide in the ethyl alcohol. After that, the mixture was put and sealed in a high pressure vessel (MM-50 available from OM LAB-TECH Co., Ltd.), and, with the sealed state maintained, reaction (chalcogenization reaction) occurred for 5 hours at 8 varieties of temperatures: 200°C, 210°C, 220°C, 230°C, 240°C, 250°C, 260°C, and 270°C, shown in Fig. 2, under pressure (under a condition where, in the hermetically sealed state, the high pressure vessel was heated to higher temperature than the boiling point of the solvent at normal pressure thereby to increase pressure in the high pressure vessel) thereby to yield products in powder form (chalcogen compound powder). The calcogen compound powder prepared at each of the temperatures was separated using filter paper. Cleaning was repeatedly performed twice on the chalcogen compound powder.

The cleaning is as follows. The cleaning involves adding the obtained powder to 50 mL of ethyl alcohol and stirring them, and then, performing centrifugation under conditions: 3000 rpm and 5 minutes, thereby removing a supernatant liquid.

The cleaned powder was dried at 80°C for 12 hours under an atmosphere of air thereby to yield dry powder of the chalcogen compound. In the embodiment, the chalcogen compound powder dried under conditions: 80°C and 12 hours under an atmosphere of air, will be hereinafter called dry powder. Also, as mentioned previously, the dry powder contains a small amount of carbon inseparable at the reaction temperature of the embodiment.

Crystal analysis was performed on the dry powder by an X-ray diffractometer (hereinafter, XRD, RAD-rX available from Rigaku Corporation) to examine specimens 1 to 8 for the state of formation of a chalcogen compound (CuInSe₂) and examine them for the reaction temperature of chalcogenization reaction required for formation of the CuInSe₂ particles. Results are shown in Fig. 2. At this time, X-ray diffraction was measured under conditions: 50 kV and 100 mA, to determine a value (hereinafter, a peak intensity ratio) obtained by dividing a peak height of the highest peak intensity of a target chalcogen compound (CuInSe₂) by a peak height of the highest peak intensity of other substances. When the peak intensity ratio was equal to or more than 15, it is judged that the target chalcogen compound was obtained with high purity (a single phase of an object was obtained), which is indicated by ○ in Fig. 2. When the peak intensity ratio was equal to or more than 5, it is judged that a substance having a high content of the target chalcogen compound was obtained, which is indicated by Δ in Fig. 2. When the peak intensity ratio was less than 5, it is judged that the content of the target chalcogen compound was low, which is indicated by ×. These evaluation criteria are the same as those for other examples.

From the results of Fig. 2, it has been shown that a reaction temperature of at least 220°C or more is required for synthesis of CuInSe₂ particles having chalcopyrite crystal structures. Also, it has been shown that a reaction temperature of at least 230°C or more is required for synthesis of high-purity CuInSe₂ particles.

Fig. 3 shows results of particle size distribution obtained by examining the particle diameter of the dry powder prepared at a chalcogenization reaction temperature of 250°C by a particle size distribution measuring instrument (NANOPHOX available from Sympatec GmbH) based on dynamic light scattering using laser light. Measurement took place with the specimen dispersed in isopropyl alcohol at a rate of 10 µg/mL. As used herein, the average particle diameter (D50) refers to a value measured by this method. Here, the average particle diameter (D50) is 50% diameter in a volume-base particle size distribution, and refers to particle diameter D (nm) obtained when Q% is equal to 50% on a graph of the volume-base particle size distribution plotted by the particle size distribution measuring instrument, that is, on a cumulative particle size curve plotted between particle diameter D (nm) represented by the axis of abscissas and volume Q (%) at which particles having a particle diameter equal to or less than the particle diameter D (nm) are present, represented by the axis of ordinates. The average particle diameter (D50) measured by this method was 42 nm. Also, as a result of examining the particle diameters of the dry powders of the specimens 4 to 8 by SEM, any specimen had an average particle diameter (D_{SEM}) of 40 nm to 45 nm. The average particle diameter (D_{SEM}) was determined by measuring the particle diameters of any 100 particles of all particles in a enlarged image of a photograph of a SEM image magnified 50,000 times by JSM6700F available from JEOL Ltd., and calculating an average value of the particle diameters.

Composition analysis using fluorescent X-rays was performed on the obtained dry powders (the specimens 6, 7 and 8). For X-ray fluorescence analysis, JSX-3201 available from JEOL Ltd. was used for measurement.

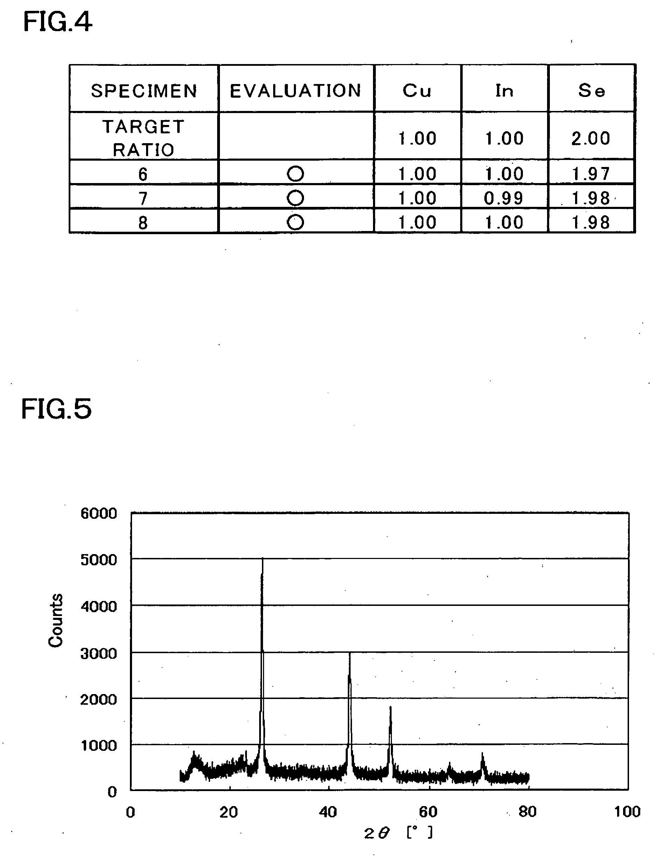

Fig. 4 shows results of the analysis, represented as the atomic ratio of constituent elements by normalization, taking Cu as 1. When a deviation of the value of the atomic ratio of each constituent element from a target value fell within 5%, this was judged as "○." Thus, it has been observed that a chalcogen compound having a composition ratio close to a target composition ratio (Cu : In : Se = 1 : 1 : 2) was obtained. Fig. 5 is a graph showing results of X-ray diffraction of the obtained chalcogen compound (the specimen 6), in which the axis of ordinates indicates peak intensity [cps], and the axis of abscissas indicates diffraction angle (2θ) [°]. Incidentally, herein, some results of the X-ray diffraction show that peaks are observed in the vicinity of 12° and in the vicinity of 22°; however, these peaks can possibly be caused by a material for a measurement stage, and therefore, calculation of the peak intensity ratio was performed without allowing for the peaks.

### COMPARATIVE EXAMPLE 1

As Comparative example 1, tests were carried out under the same conditions as those for Example 1, except that pure water was used in place of ethyl alcohol, as the solvent used for the chalcogenization reaction.

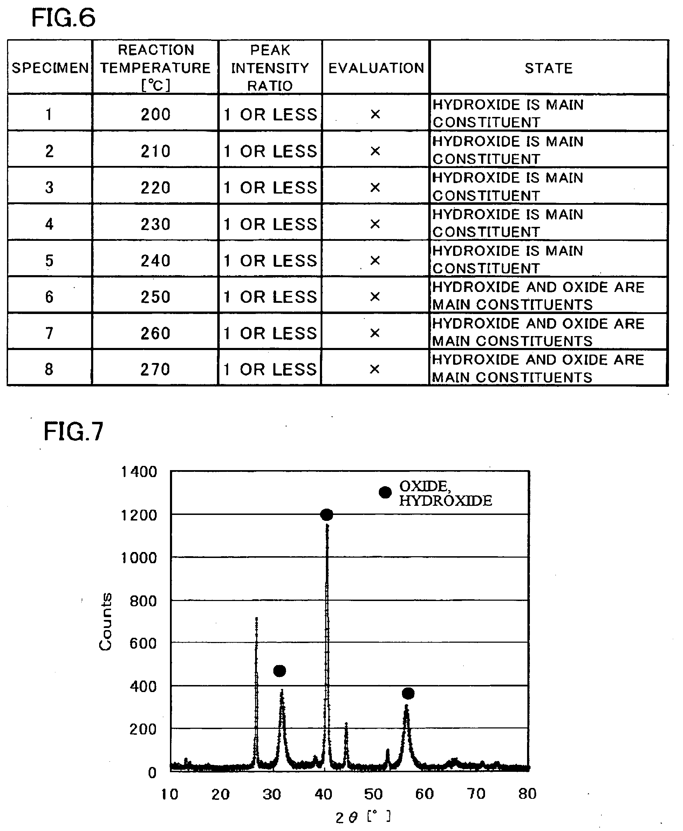

Fig. 6 shows results obtained by examining the obtained dry powders by X-ray diffraction in the same manner as Example 1 and evaluating them in the same manner as Example 1. With any specimen, synthesis of CuInSe₂ particles was not possible.

Fig. 7 shows results of analysis performed by XRD on the specimen 6 of Comparative example 1. The results of Fig. 7 showed that a hydroxide and an oxide were main constituents.

### COMPARATIVE, EXAMPLE 2

As Comparative example 2, tests were carried out under the same conditions as those for Example 1, except that tetraethylene glycol was used as the solvent used for the chalcogenization reaction.

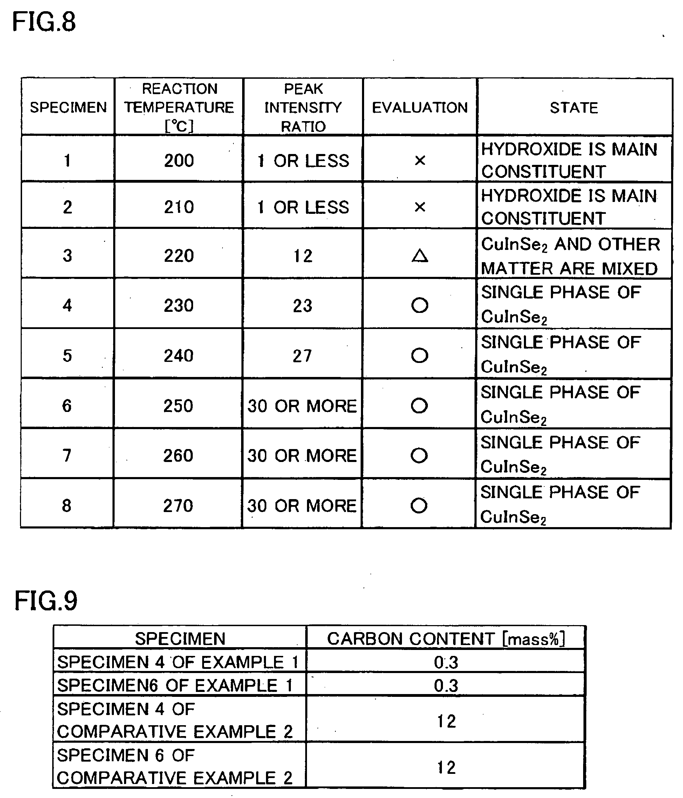

Fig. 8 shows results obtained by examining the obtained dry powders by X-ray diffraction in the same manner as Example 1 and evaluating them in the same manner as Example 1. The results showed the same tendency as that of Example 1.

The specimens 4 and 6 of Example 1 and the specimens 4 and 6 of Comparative example 2 were heated at 140°C for 1 hour in air to eliminate organic matter removable with low-temperature heating, and were then cooled to room temperature, and thereafter, the carbon content in the specimens was evaluated by wavelength dispersive X-ray fluorescence analysis. For evaluation, a wavelength dispersive X-ray fluorescence analysis instrument (S8 TIGER available from Bruker AXS Inc.) was used as an instrument to measure the carbon content in the specimens and calculate the carbon content on a mass percentage basis.

Fig. 9 shows results of this measurement. The dry powders of Example 1 had the dramatically reduced content of carbon, as compared to those of Comparative example 2. Thus, as described later, use of the chalcogen compound powder of the embodiment enables formation of a thin film of chalcogen compound having low sheet resistivity.

Then, pastes were prepared using the dry powders of the specimens 4 and 6 of Example 1 and the specimens 4 and 6 of Comparative example 2, and thin films of chalcogen compounds were formed by coating and calcination of the pastes, and electrical conductivity of the films was evaluated by the following method.

For each of the dry powders of the specimens 4 and 6, the dry powder and diethylene glycol were mixed together for 10 minutes by an agitator (a planetary ball mill, puluerisette 5 available from FRITSCH GmbH) thereby to prepare paste, in such a manner that the content of the dry powder was 50% by mass. A coating of the paste was applied, by using a bar coater, in a thickness of 10 µm to a substrate having a Mo film formed in a thickness of 1 µm on blue sheet glass, and this coating film was dried at 110°C for 1 hour in the air. The coating film was heated at 250°C for 2 hours in the air. After that, calcination took place at 575°C for 1 hour in an atmosphere of a mixed gas of nitrogen and hydrogen (containing 5% by volume of hydrogen gas) thereby to form a thin film of chalcogen compound (a CuInSe₂ film).

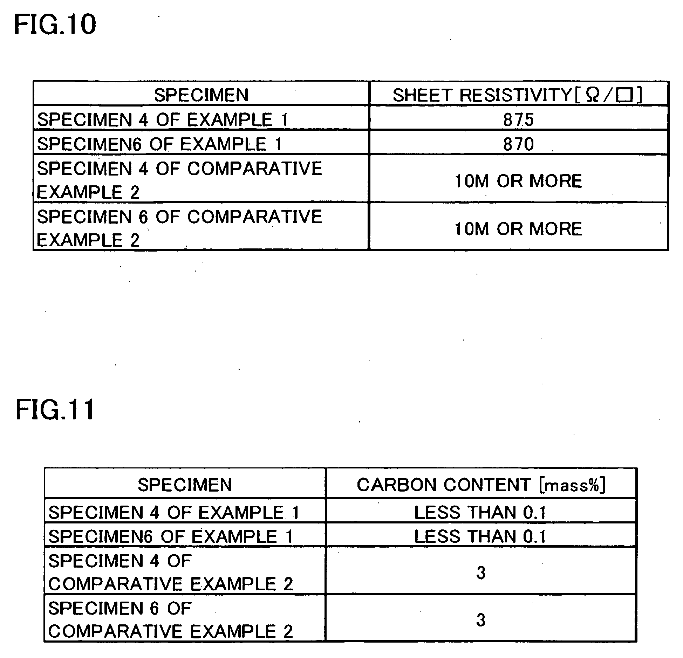

Fig. 10 shows results of measurement of sheet resistivity of the thin films of chalcogen compounds, using MCP-T410 available from Mitsubishi Chemical Corporation. When the dry powders of Comparative example 2 were used, the sheet resistivity of the films was equal to or more than 10 MΩ/□ and hence measured values could not be obtained, whereas when the dry powders (the specimens 4 and 6) of Example 1 were used, the sheet resistivity of the films was less than 1000 Ω/□. Thin films of chalcogen compounds were prepared under the same conditions as described above, except that, at the time of preparation of paste, the content of dry powder was changed from 50% by mass to 20% by mass, 40% by mass, and 70% by mass, and measured results of sheet resistivity of the thin films were the same as described above: when the dry powders of Comparative example 2 were used, the sheet resistivity of the films was equal to or more than 10 MΩ/□ and hence measured values could not be obtained, whereas when the dry powders (the specimens 4 and 6) of Example 1 were used, it was observed that the sheet resistivity of the films was less than 1000 Ω/□.

As mentioned previously, the sheet resistivity is desired to be low for the thin film of chalcogen compound for use in the solar cell or the like. Specifically, it is desirable that the sheet resistivity be equal to or less than 1000 Ω/□, and the specimens 4 and 6 of Example 1 could satisfy the sheet resistivity.

Fig. 11 shows results of evaluation of the carbon content in the films formed using four types of dry powders, respectively: the specimens 4 and 6 of Example 1 and the specimens 4 and 6 of Comparative example 2, by SEM-EDS. When the films formed using the dry powders of Comparative example 2 were measured for the carbon content, the measured content of carbon was 3% by mass, whereas when the films formed using the dry powders of Example 1 were measured for the carbon content, it was shown that the measured content of carbon was less than 0.1% by mass, which was low. Also, in other words, in the embodiment, the content of carbon in the dry powder (the chalcogen compound powder) is low, and thus, it may be said that a sheet resistance value of the thin film of chalcogen compound using this powder is greatly reduced.

### EXAMPLE 2

To synthesize CuInSe₂ particles, tests were carried out in the same manner as Example 1, except that substances heated for the chalcogenization reaction were changed to 0.01 mol of copper chloride, 0.01 mol of indium chloride, 0.021 mol of Se powder, and 50 mL of ethyl alcohol, and that a time for heating to each of the temperatures shown in Fig. 2 was changed to 12 hours.

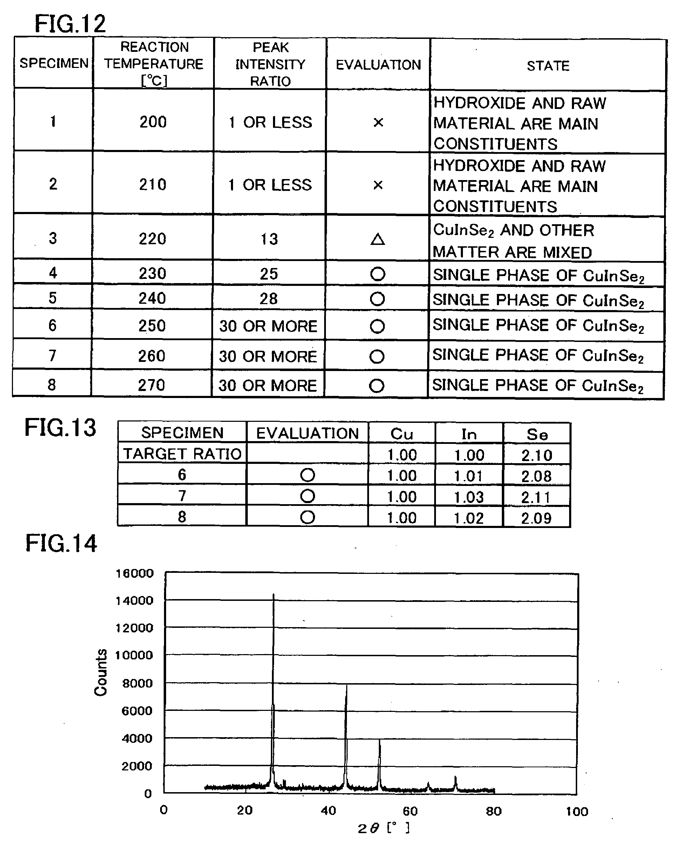

Fig. 12 shows results of evaluation by XRD, and results of evaluation by the same evaluation method as that for Example 1. From Fig. 12, it has been shown that a reaction temperature of at least 220°C or more is required for synthesis of CuInSe₂ particles having chalcopyrite crystal structures. Also, it has been shown that a reaction temperature of at least 230°C or more is required for synthesis of high-purity CuInSe₂ particles. As a result of examining the particle diameter of the dry powder (the specimen 6) prepared at 250°C by SEM, the average particle diameter (D_{SEM}) was 40 nm.

Fig. 13 shows results of composition analysis using fluorescent X-rays, performed on the specimens 6, 7 and 8. From the results, it has been shown that crystal powder having a composition ratio close to a target composition ratio is formed.

Fig. 14 shows results of analysis performed by XRD on the specimen 6 prepared at 250°C.

### COMPARATIVE EXAMPLE 3

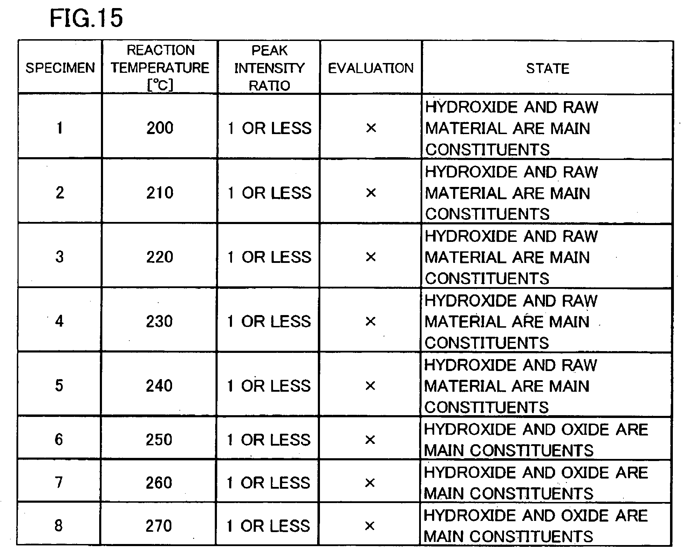

As Comparative example 3, tests were carried out under the same conditions as those for Example 2, except that pure water was used in place of ethyl alcohol, as the solvent used for the chalcogenization reaction. Fig. 15 shows results of evaluation by XRD, and results of evaluation by the same evaluation as that for Example 1. With any specimen, synthesis of CuInSe₂ particles was not possible.

### EXAMPLE 3

To synthesize Cu_{0.9}In_{0.5}Ga_{0.5}Se_{2.2} particles, tests were carried out in the same manner as Example 1, except that starting materials were changed from 0.1 mol of copper nitrate and 0.1 mol of indium nitrate to 0.09 mol of copper nitrate, 0.05 mol of indium nitrate and 0.05 mol of gallium nitrate, and that the amount of Se added for the chalcogenization reaction was changed from an amount such that an atomic ratio of Se to Cu contained in the hydroxide stands at 2.2 to an amount such that the atomic ratio stands at 2.42. In Example 1, the water content in the cake of the obtained hydroxide was 73% by mass, whereas in Example 3, the water content was 69% by mass.

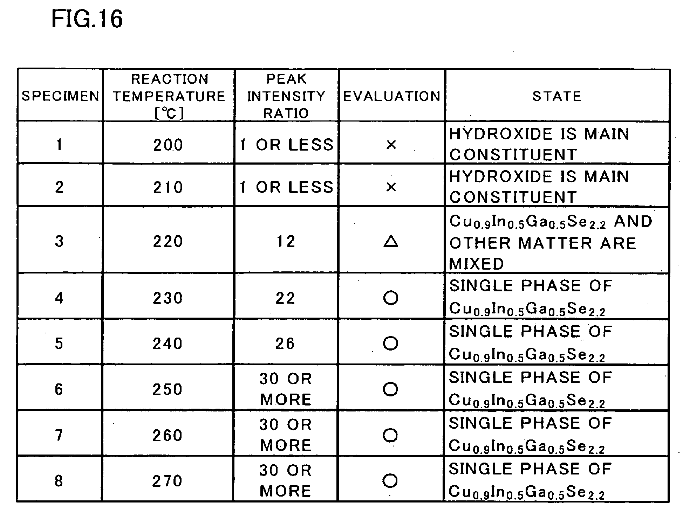

Fig. 16 shows results of crystal analysis by XRD, and results of evaluation by the same evaluation method as that for Example 1. From the results, it has been shown that a reaction temperature of at least 220°C or more is required for synthesis of Cu_{0.9}In_{0.5}Ga_{0.5}Se_{2.2} particles having chalcopyrite crystal structures. Also, it has been shown that a reaction temperature of at least 230°C or more is required for synthesis of high-purity CuInSe₂ particles.

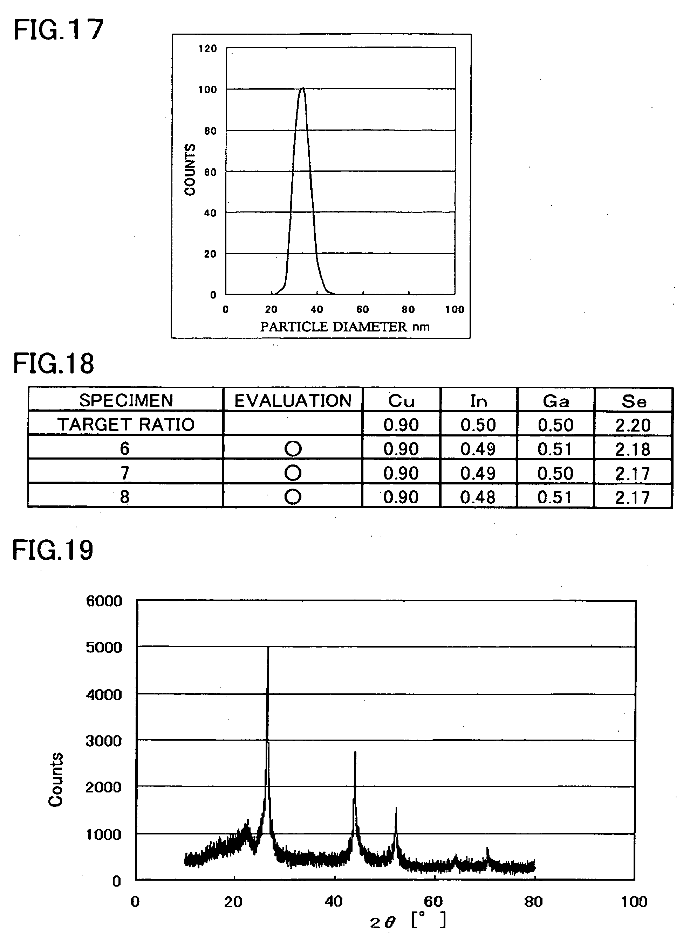

Fig. 17 shows results of particle size distribution of the powder (the specimen 6) prepared at 250°C, examined by the particle size distribution measuring instrument using laser scattering. Also, the average particle diameter (D_{SEM}) of the dry powder of the specimen 6 was 35 nm.

Fig. 18 shows results of composition analysis using fluorescent X-rays, performed on the specimens 6, 7 and 8. The results of Fig. 18 were determined by calculating the composition ratio by normalization, taking Cu as 0.9. From the results, it has been shown that crystal powder having a composition ratio close to a target composition ratio is formed.

Fig. 19 shows results of analysis performed by XRD on the specimen 6 prepared at 250°C.

The carbon content in the dry powders of the specimens 4 to 8 measured in the same manner as Example 1 is between 0.3% and 0.4% by mass, and, when the dry powders of the specimens 4 and 8 were used, with any specimen, the sheet resistivity of the films measured in the same manner as Example 1 was less than 1000 Ω/□.

### COMPARATIVE EXAMPLE 4

As Comparative example 4, tests were carried out under the same conditions as those for Example 3, except that pure water was used in place of ethyl alcohol, as the solvent used for the chalcogenization reaction.

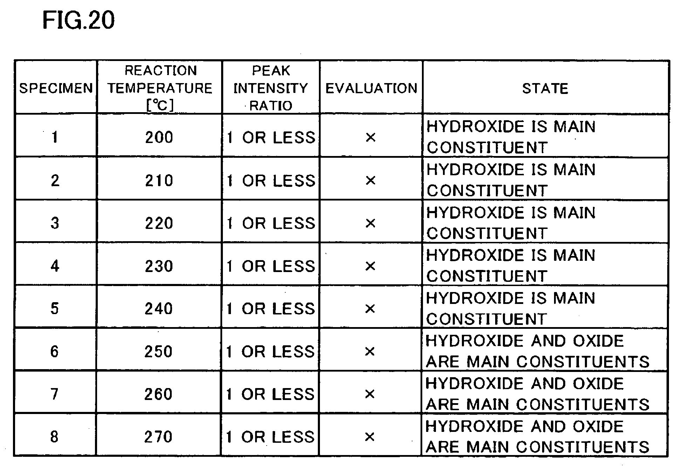

Fig. 20 shows results of evaluation by XRD, and results of evaluation by the same evaluation as that for Example 1. With any specimen, synthesis of Cu_{0.9}In_{0.5}Ga_{0.5}Se_{2.2} particles was not possible.

### EXAMPLE 5

To synthesize Cu_{0.85}In_{1.00}Se_{2.05} particles, a solution containing 0.085 mol of copper nitrate and 0.1 mol of indium nitrate dissolved in 500 mL of pure water was poured into a 1000 mL beaker. Subsequently, with the solution in the beaker stirred with a blade of 5 cm in diameter at 300 rpm, a 40 g/L aqueous solution of sodium hydroxide was dripped until the solution reached pH 7.9, thereby to form a precipitate as a hydroxide and obtain a composite hydroxide of copper and indium. In this state, the composite hydroxide was allowed to stand for 30 minutes, and thereafter, solid-liquid separation was performed by a Nutsche. At this time, extracted cake of the composite hydroxide of copper and indium was dispersed again in pure water, and the solid-liquid separation was performed by a Nutsche in the same manner. Above-mentioned process was repeated until conductivity of filtrate reached 10⁻³ Sm⁻¹ or less. Part of the cake taken out was dried by heat (at 80°C for 12 hours in an atmosphere of air), and a water content in the cake was determined from mass before and after drying by heat. The obtained water content in the cake was 68% by mass.

Then, 5 g of the composite hydroxide dried by heat was taken out. Se powder was prepared by being weighed in an amount such that an atomic ratio of Se to Cu contained in the composite hydroxide stands at 2.05. Then, 5 g of the composite hydroxide and the weighed Se powder were put in a 50 mL vessel made of fluorocarbon resin, and 20 mL of methyl alcohol was added to them. In this state, the vessel was agitated to disperse the composite hydroxide. After that, the mixture was put and sealed in a high pressure vessel (MM-50 available from OM LAB-TECH Co., Ltd.), and, with the sealed state maintained, reaction (chalcogenization reaction) occurred for 5 hours at a temperature of 250°C thereby to yield products in powder form (chalcogen compound powder).

The calcogen compound powder prepared at each of the temperatures was separated using filter paper. Cleaning was repeatedly performed twice on the calcogen compound powder.

The cleaning is as follows. The cleaning involves adding the obtained powder to 50 mL of ethyl alcohol and stirring them, and then, performing centrifugation under conditions: 3000 rpm and 5 minutes, thereby removing a supernatant liquid.

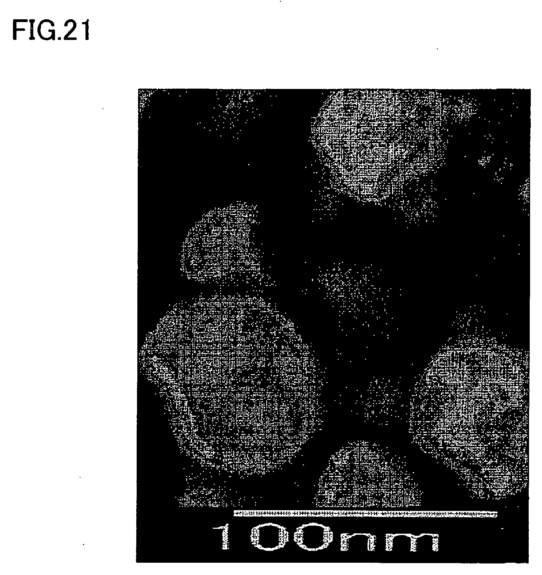

The cleaned powder was dried at 80°C for 12 hours in an atmosphere of air thereby to yield dry powder (the specimen 1). Fig. 21. shows a scanning electron microscope photograph of the dry powder (the specimen 1).

Dry powders (the specimens 2 to 8) were obtained in the same manner as described above, except that ethyl alcohol, 2-propanol, 1-butanol, 1-pentanol, diethylene glycol, triethylene glycol, and tetraethylene glycol were used as the solvent in place of methyl alcohol. Here, the specimens 1 and 2 are those of the example, and the specimens 3 to 8 are those of the comparative example.

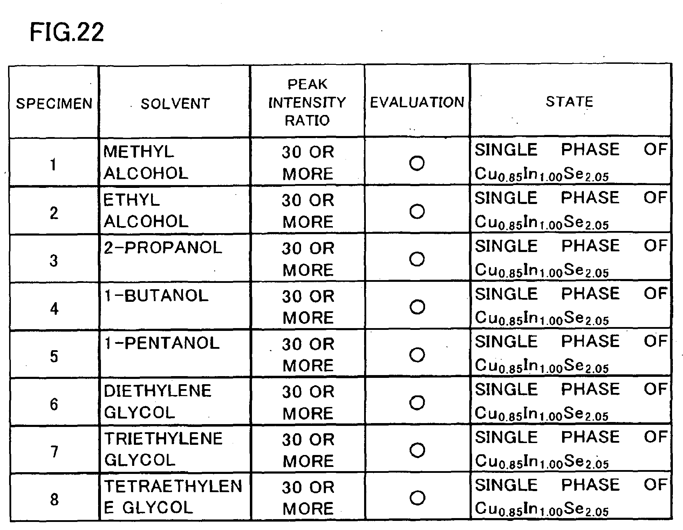

Fig. 22 shows results of crystal analysis performed by XRD on the dry powders produced using each of the solvents, and results of evaluation of them by the same method as that for Example 1.

With any solvent, Cu_{0.85}In_{1.00}Se_{2.05} particle powder having chalcopyrite crystal structures could be obtained as shown in Fig. 22.

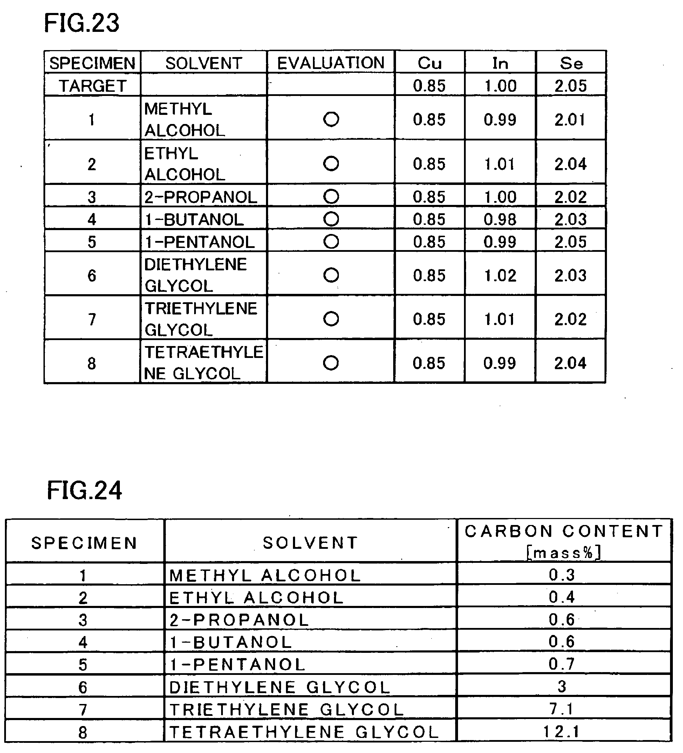

Also, Fig. 23 shows the composition ratio of them obtained by X-ray fluorescence analysis.

Further, Fig. 24 shows results of measurement of carbon content made on the dry powders by the above-described method using wavelength dispersive X-ray fluorescence analysis. From the results, it has been shown that the dry powder produced using the solvent having a high boiling point (high molecular weight) has a high carbon content.

Then, for each of the dry powders of the specimens 1 to 8, the dry powder and diethylene glycol having the same mass as the dry powder were stirred and mixed together thereby to prepare a fluid dispersion (paste) of Cu_{0.85}In_{1.00}Se_{2.05} particles having a concentration of 50% by weight. A coating of the fluid dispersion was applied in a thickness of 10 µm to a glass substrate by bar coating method, and this coating film was dried at 110°C for 1 hour in the air. The coating film was heated at 250°C for 2 hours in the air. After that, calcination took place at 575°C for 1 hour in an atmosphere of a mixed gas of nitrogen and hydrogen (containing 5% by volume of hydrogen gas) thereby to obtain a thin film of chalcogen compound.

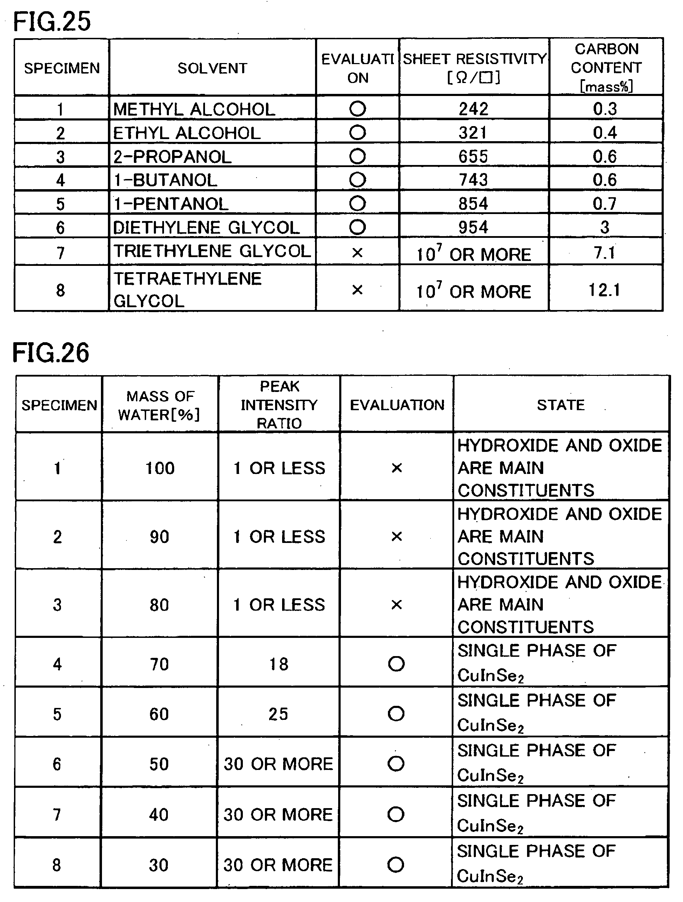

Fig. 25 shows results of measurement of sheet resistivity of the thin films of chalcogen compounds prepared. The results of Fig. 25 show that the film formed using the paste having blended therewith the dry powder having a high content of carbon adhering thereto has high sheet resistivity. The carbon content in the dry powder should be equal to or less than 0.5% by mass. Incidentally, the sheet resistivity of the thin film of chalcogen compound prepared using the specimen 2 of Example 5 is lower as compared to the sheet resistivity of the thin film of chalcogen compound prepared using the specimen 6 of Example 1, which can possibly be caused by a difference in the composition of the chalcogen compound.

### EXAMPLE 6

Tests were carried out in the same manner as Example 1, except that the solvent used for the chalcogenization reaction was changed from ethyl alcohol to a mixed solvent of ethyl alcohol and water or to water (8 varieties of water content ratio (30% to 100% by mass) shown in Fig. 26), that the temperature for the chalcogenization reaction was set only to 250°C, and that the amount of Se added for the chalcogenization reaction was changed from an amount such that an atomic ratio of Se to Cu contained in the hydroxide stands at 2.2 to an amount such that the atomic ratio stands at 2.0.

Fig. 26 shows results of crystal analysis by XRD, and results of evaluation by the same evaluation as that for Example 1. In Fig. 26, the specimens 1 to 3 are those of the comparative example, and the specimens 4 to 8 are those of the example. From the results, it has been shown that, for synthesis of particles having chalcopyrite crystal structures, the water content in the mixed solvent of water and ethyl alcohol should be equal to or less than 70% by mass, or more preferably equal to or less than 50% by mass.

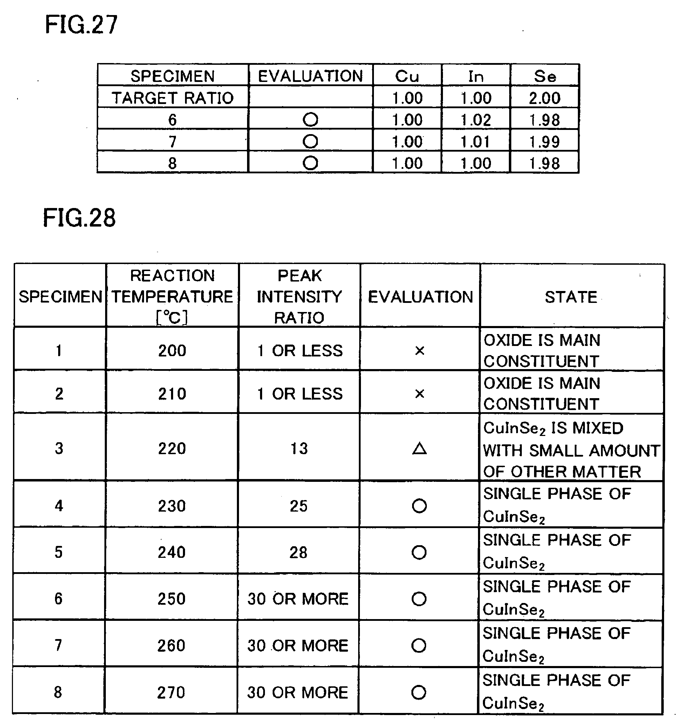

Also, Fig. 27 shows the element composition ratio of the specimens 6, 7 and 8 determined by using X-ray fluorescence.

The carbon content in the dry powders of the specimens 4 to 8 measured in the same manner as Example 1 lay between 0.3% and 0.4% by mass. As for the sheet resistivity of the films measured in the same manner as Example 1, the sheet resistivity was 870 Ω/□ when the dry powder of the specimen 4 was used, and the sheet resistivity was 850 Ω/□ when the dry powder of the specimen 8 was used.

### EXAMPLE 7

In Example 1, for the chalcogenization reaction for synthesis of CuInSe₂ particles, the composite hydroxide of metals was used as the metal source, whereas in this Example, the composite hydroxide was once heated to form a composite oxide, and thereafter, the composite oxide was put in a high pressure vessel to undergo reaction. In Example 1, the cake of the composite hydroxide after the cleaning was dried under conditions: 80°C and 12 hours in air, and thereafter, the composite hydroxide was subjected to heat treatment at 350°C for 3 hours in air thereby to prepare metal compound powder of the composite oxide. Tests were carried out in the same manner as Example 1, except that 5 g of the composite oxide was used in place of 5 g of the composite hydroxide used for the chalcogenization reaction, that the amount of ethyl alcohol used for the chalcogenization reaction was changed to 30 mL, and that the amount of Se added for the chalcogenization reaction was changed from an amount such that an atomic ratio of Se to Cu contained in the hydroxide stands at 2.2 to an amount such that the atomic ratio stands at 2.1.

Fig. 28 shows results of evaluation by XRD, and results of evaluation by the same evaluation as that for Example 1. From the results, it has been shown that a reaction temperature of at least 220°C or more is required for synthesis of particles having chalcopyrite crystal structures. Also, it has been shown that a reaction temperature of at least 230°C or more is required for synthesis of high-purity CuInSe₂ particles.

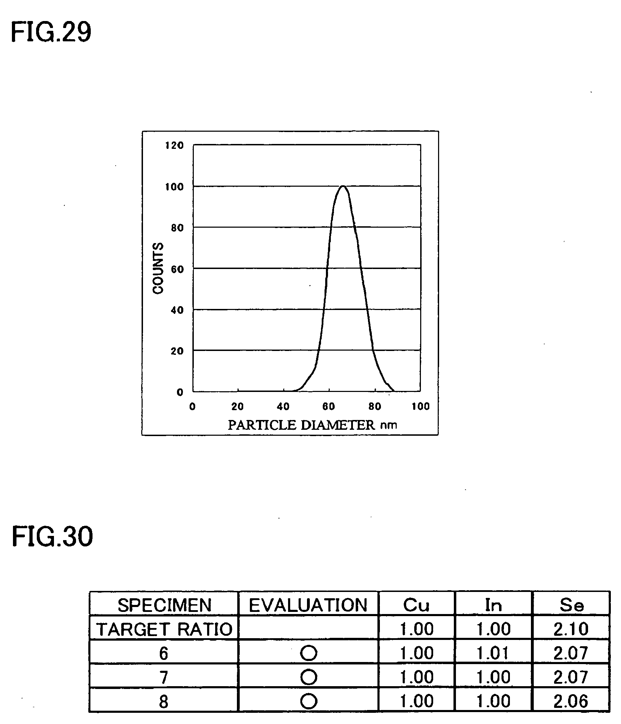

Fig. 29 shows results of particle size distribution of the dry powder (the specimen 6) prepared at 250°C, examined by the particle size distribution measuring instrument using laser scattering. As a result of examining the particle diameter of the specimen 6 by SEM, the average particle diameter (D_{SEM}) was 75 nm.

Fig. 30 shows results of composition analysis using fluorescent X-rays, performed on the specimens 6, 7 and 8. The results of Fig. 30 were determined by calculating the composition ratio by normalization, taking Cu as 1. From the results, it has been shown that crystal powder having a composition ratio close to a target composition ratio is formed.

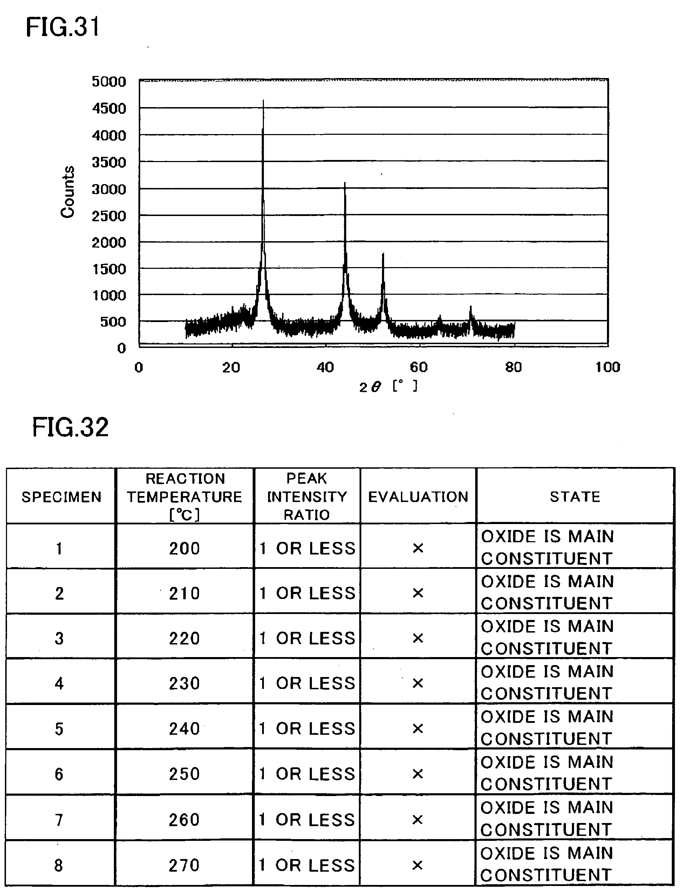

Fig. 31 shows results of the specimen 6 by XRD.

The carbon content in the dry powders of the specimens 4 to 8 measured in the same manner as Example 1 is between 0.3% and 0.4% by mass, and, when the dry powders of the specimens 4 and 8 were used, with any specimen, the sheet resistivity of the films measured in the same manner as Example 1 was less than 1000 Ω/□.

### COMPARATIVE EXAMPLE 7

As Comparative example 7, tests were carried out under the same conditions as those for Example 7, except that pure water was used in place of ethyl alcohol, as the solvent used for the chalcogenization reaction.

Fig. 32 shows results of the tests. With any specimen, synthesis of CuInSe₂ particles was not possible.

## Claims

1. Chalcogen compound powder, represented as a general formula: CuₐIn_{b}Ga_{1-b}Se_{c} (where 0.65 ≤ a ≤ 1.2, 0 < b ≤ 1, and 1.9 ≤ c ≤ 2.4), having an average particle diameter (D_{SEM}) of 1 nm to 80 nm measured by observation under a scanning electron microscope, and having a carbon content of 0.5% or less by mass.

2. Chalcogen compound paste, comprising the chalcogen compound powder according to claim 1 and a disperse medium.

3. The chalcogen compound paste according to claim 2, wherein the disperse medium is alcohol.

4. The chalcogen compound paste according to claim 3, wherein the content of the chalcogen compound powder in the alcohol is between 20% and 80% by mass.

5. A process for producing the chalcogen compound powder according to claim 1, comprising the steps of:
forming a mixed solvent by mixing together a metal source containing copper and indium, any one of selenium and a selenium compound, and a polar solvent; and
heating the mixed solvent to a temperature of 220°C to 500°C using a vessel capable of being heated under pressure,
wherein the polar solvent is an organic solvent, selected from methyl alcohol or ethyl alcohol, or a mixed solvent of the organic solvent and water, wherein the solvent contains 70% or less by mass of water.

6. The process for producing the chalcogen compound powder according to claim 5, wherein the polar solvent is methyl alcohol or ethyl alcohol.

7. The process for producing the chalcogen compound powder according to claim 5, wherein the metal source is at least any one of a mixture of copper salt and indium salt, a composite hydroxide of copper and indium, and a composite oxide of copper and indium.

8. The process for producing the chalcogen compound powder according to claim 7, wherein the mixture contains gallium salt.

9. The process for producing the chalcogen compound powder according to claim 7, wherein the composite hydroxide contains gallium.

10. The process for producing the chalcogen compound powder according to claim 7, wherein the composite oxide contains gallium.

11. The process for producing the chalcogen compound powder according to any one of claims 5 to 10, wherein the heating is performed in a pressure vessel.

12. A process for producing chalcogen compound paste, comprising the step of mixing together the chalcogen compound powder according to claim 1 and a disperse medium.

13. The process for producing chalcogen compound paste according to claim 12, wherein the disperse medium is alcohol.

14. The process for producing chalcogen compound paste according to claim 12 or 13, wherein the content of the chalcogen compound powder in the chalcogen compound paste is between 20% and 80% by mass.

## Patentansprüche

1. Pulver einer Chalkogenverbindung, dargestellt als eine allgemeine Formel: CuₐIn_{b}Ga_{1-b}Se_{c} (wobei 0,65 ≤ a ≤ 1,2, 0 < b ≤ 1 und 1,9 ≤ c ≤ 2,4), das einen mittleren Teilchendurchmesser (D_{SEM}) von 1 nm bis 80 nm aufweist, gemessen durch Beobachtung unter einem Rasterelektronenmikroskop, und einen Kohlenstoffanteil von 0,5 Masse-% oder weniger aufweist.

2. Paste einer Chalkogenverbindung, umfassend das Pulver einer Chalkogenverbindung nach Anspruch 1 und ein Dispergiermedium.

3. Paste einer Chalkogenverbindung nach Anspruch 2, wobei das Dispergiermedium Alkohol ist.

4. Paste einer Chalkogenverbindung nach Anspruch 3, wobei der Anteil des Pulvers einer Chalkogenverbindung im Alkohol zwischen 20 Masse-% und 80 Masse-% beträgt.

5. Verfahren zur Herstellung des Pulvers einer Chalkogenverbindung nach Anspruch 1, umfassend die Schritte des:
Bildens eines gemischten Lösungsmittels durch das Zusammenmischen einer Metallquelle, enthaltend Kupfer und Indium, eines aus Selen und einer Selenverbindung und eines polaren Lösungsmittels; und
Erwärmens des gemischten Lösungsmittels auf eine Temperatur von 220°C bis 500°C unter Verwendung eines Behälters, der geeignet ist unter Druck erwärmt zu werden,
wobei das polare Lösungsmittel ein organisches Lösungsmittel, ausgewählt aus Methylalkohol oder Ethylalkohol, oder ein gemischtes Lösungsmittel aus dem organischen Lösungsmittel und Wasser ist, wobei das Lösungsmittel 70 Masse% oder weniger Wasser enthält.

6. Verfahren zur Herstellung des Pulvers einer Chalkogenverbindung nach Anspruch 5, wobei das polare Lösungsmittel Methylalkohol oder Ethylalkohol ist.

7. Verfahren zur Herstellung des Pulvers einer Chalkogenverbindung nach Anspruch 5, wobei die Metallquelle mindestens eines aus einem Gemisch von Kupfersalz und Indiumsalz, einem Composite-Hydroxid von Kupfer und Indium, und einem Composite-Oxid von Kupfer und Indium ist.

8. Verfahren zur Herstellung des Pulvers einer Chalkogenverbindung nach Anspruch 7, wobei das Gemisch Galliumsalz enthält.

9. Verfahren zur Herstellung des Pulvers einer Chalkogenverbindung nach Anspruch 7, wobei das Composite-Hydroxid Gallium enthält.

10. Verfahren zur Herstellung des Pulvers einer Chalkogenverbindung nach Anspruch 7, wobei das Composite-Oxid Gallium enthält.

11. Verfahren zur Herstellung des Pulvers einer Chalkogenverbindung nach einem der Ansprüche 5 bis 10, wobei das Erwärmen in einem Druckbehälter durchgeführt wird.

12. Verfahren zur Herstellung einer Paste einer Chalkogenverbindung, umfassned den Schritt des Zusammenmischens des Pulvers einer Chalkogenverbindung nach Anspruch 1 und eines Dispergiermediums.

13. Verfahren zur Herstellung einer Paste einer Chalkogenverbindung nach Anspruch 12, wobei das Dispergiermedium Alkohol ist.

14. Verfahren zur Herstellung einer Paste einer Chalkogenverbindung nach Anspruch 12 oder 13, wobei der Anteil des Pulvers einer Chalkogenverbindung in der Paste einer Chalkogenverbindung zwischen 20 Masse-% und 80 Masse-% beträgt.

## Revendications

1. Composé chalcogène de type poudre, représenté par la formule générale : CuₐIn_{b}Ga_{1-b}Se_{c} (où 0,65 ≤ a ≤ 1,2, 0 < b ≤ 1, et 1,9 ≤ c ≤ 2,4), ayant un diamètre moyen de particules (D_{MEB}) de 1 nm à 80 nm mesuré par observation sous un microscope électronique à balayage, et ayant un contenu en carbone de 0,5 % ou moins en masse.

2. Composé chalcogène de type pâte, comprenant le composé chalcogène de type poudre selon la revendication 1 et un milieu dispersant.

3. Le composé chalcogène de type pâte selon la revendication 2, dans lequel le milieu dispersant est de l'alcool.

4. Le composé chalcogène de type pâte selon la revendication 3, dans lequel la teneur du composé chalcogène de type poudre dans l'alcool est située entre 20% et 80% en masse.

5. Un procédé pour produire le composé chalcogène de type poudre selon la revendication 1, comprenant les étapes de :
formation d'un solvant mélangé en mélangeant ensemble une source métallique contenant du cuivre et de l'indium, l'un quelconque du sélénium et d'un composé sélénium et un solvant polaire ; et
chauffage du solvant mélangé à une température de 220°C à 500°C en utilisant un récipient capable d'être chauffé sous pression,
où le solvant polaire est un solvant organique, sélectionné parmi l'alcool méthylique ou l'alcool éthylique, ou un mélange de solvant du solvant organique et d'eau, dans lequel le solvant contient 70% ou moins en masse d'eau.

6. Le procédé pour produire le composé chalcogène de type poudre selon la revendication 5, dans lequel le solvant polaire est l'alcool méthylique ou l'alcool éthylique.

7. Le procédé pour produire le composé chalcogène de type poudre selon la revendication 5, dans lequel la source métallique est au moins l'un quelconque d'un mélange de sel de cuivre et de sel d'indium, un hydroxyde composite de cuivre et indium, et un oxyde composite de cuivre et indium.

8. Le procédé pour produire le composé chalcogène de type poudre selon la revendication 7, dans lequel le composite contient du sel de gallium.

9. Le procédé pour produire le composé chalcogène de type poudre selon la revendication 7, dans lequel l'hydroxyde composite contient du gallium.

10. Le procédé pour produire le composé chalcogène de type poudre selon la revendication 7, dans lequel l'oxyde composite contient du gallium.

11. Le procédé pour produire le composé chalcogène de type poudre selon l'une quelconque des revendications 5 à 10, dans lequel le chauffage est réalisé dans un récipient capable d'être chauffé sous pression.

12. Le procédé pour produire un composé chalcogène de type pâte, comprenant l'étape de mélanger ensemble le composé chalcogène de type poudre selon la revendication 1 et un milieu dispersant.

13. Le procédé pour produire un composé chalcogène de type pâte selon la revendication 12, dans lequel le milieu dispersant est l'alcool.

14. Le procédé pour produire un composé chalcogène de type pâte selon l'une quelconque des revendications 12 ou 13, dans lequel la teneur en composé chalcogène de type poudre dans le composé chalcogène de type pâte est entre 20% et 80% en masse.
